# EUROPEAN PATENT APPLICATION

(11) **EP 4 254 494 A1**
(43) Date of publication of application: **04.10.2023**
(21) Application number: 23156446.9
(22) Date of filing: 14.02.2023
(51) Int. Cl.: H01L 23/538

(54) **GLASS BRIDGE FOR CONNECTING DIES**

(30) Priority: 29.03.2022 US 202217707157
(71) Applicant: Intel Corporation, Santa Clara, CA 95054 (US)
(72) Inventor: Hanna, Carlton, Chandler, 95126 (US); Seidemann, Georg, 84036 Landshut (DE); De Mesa, Eduardo, Munich (DE); Bacha, Abdallah, 80805 Munich (DE); Keser, Lizabeth, San Diego, 92127 (US)
(74) Representative: Goddar, Heinz J.

(57) **Abstract**

An electronic device comprises a substrate including an organic material; a glass bridge die included in the substrate, the glass bridge die including electrically conductive interconnect; and a first integrated circuit (IC) die and at least a second IC die arranged on a surface of the substrate and including bonding pads connected to the interconnect of the glass bridge die.

## Description

### TECHNICAL FIELD

Embodiments pertain to packaging of integrated circuits (ICs). Some embodiments relate to a package substrate having a stiffening layer mode of ceramic or glass.

### BACKGROUND

Electronic systems often include integrated circuits (ICs) that are interconnected and packaged as a subassembly. It is desired to integrate multiple types of IC dies into a single package to create an efficient system in a package. However, as packaged electronic systems become larger due to adding more IC dies, the area form factor (e.g., X-Y dimensions) of the packages becomes larger. If the area form factor of a package becomes too large, the package can be susceptible to warping. Thus, there are general needs for devices, systems and methods that address the size challenges for interconnection and packaging of electronic systems.

### BRIEF DESCRIPTION OF THE DRAWINGS

FIG. 1 is an illustration of a portion of an electronic assembly that includes two silicon dies and a redistribution layer that is an organic bridge in accordance with some embodiments;
FIG. 2 is an illustration of a portion of another electronic assembly that includes two silicon dies and a redistribution layer that is a silicon bridge in accordance with some embodiments;
FIG. 3 is an illustration of a portion of another electronic assembly that includes two silicon dies and a redistribution layer that is a glass bridge in accordance with some embodiments;
FIG. 4 is an illustration of an example of a multi-layer glass bridge in accordance with some embodiments;
FIG. 5 is an illustration of an example of portions of an electronic device having a substrate that includes a stiffening ceramic core layer in accordance with some embodiments;
FIGS. 6A-6F illustrate portions of an example of a process flow of forming a substrate having a stiffening ceramic core layer in accordance with some embodiments;
FIG. 7 is an illustration of an example of portions of an electronic device having a substrate that includes a stiffening glass core layer in accordance with some embodiments;
FIGS. 8A-8F illustrate portions of an example of a process flow of forming a substrate having a stiffening glass core layer in accordance with some embodiments;
FIG. 9 is an illustration of an example of portions of an electronic device having a substrate that includes a stiffening ceramic carrier layer in accordance with some embodiments;
FIGS. 10A-10K illustrate portions of an example of a process flow of forming a substrate having a stiffening ceramic carrier layer in accordance with some embodiments;
FIG. 11 is an illustration of an example of portions of an electronic device having a substrate that includes a stiffening glass carrier layer in accordance with some embodiments;
FIGS. 12A-12K illustrate portions of an example of a process flow of forming a substrate having a stiffening glass carrier layer in accordance with some embodiments;
FIG. 13 illustrates a system level diagram in accordance with some embodiments.

### DETAILED DESCRIPTION

The following description and the drawings sufficiently illustrate specific embodiments to enable those skilled in the art to practice them. Other embodiments may incorporate structural, logical, electrical, process, and other changes. Portions and features of some embodiments may be included in, or substituted for, those of other embodiments. Embodiments set forth in the claims encompass all available equivalents of those claims.

To meet the demand for increased functional complexity in smaller devices, manufacturers integrate multiple types of integrated circuits (ICs) dies in a single electronic package to create an efficient electronic system in a package. For example, chiplets are a technique for integrating various processing functionality. Generally, a chiplet system is made up of discrete chips (e.g., ICs on different substrates or dies) that are packaged together. This arrangement is distinct from single chips that contain distinct device blocks on one substrate (e.g., single die), such as a system-on-a-chip (SoC), or discretely packaged devices integrated on a board. In general, chiplets provide better performance (e.g., lower power consumption, reduced latency, etc.) than discretely packaged devices, and chiplets provide greater production benefits than single die chips. These production benefits can include higher yields or reduced development costs and time.

To realize a chiplet-based system the individual chiplet dies can be connected using connection dies known as bridges. Bridges serve as an in-package interconnect for multiple die packages that transmit large amounts of data. As the number of chiplets in a system increases, it is desired to use interconnect routing having a very fine pitch to keep the system dimensions small.

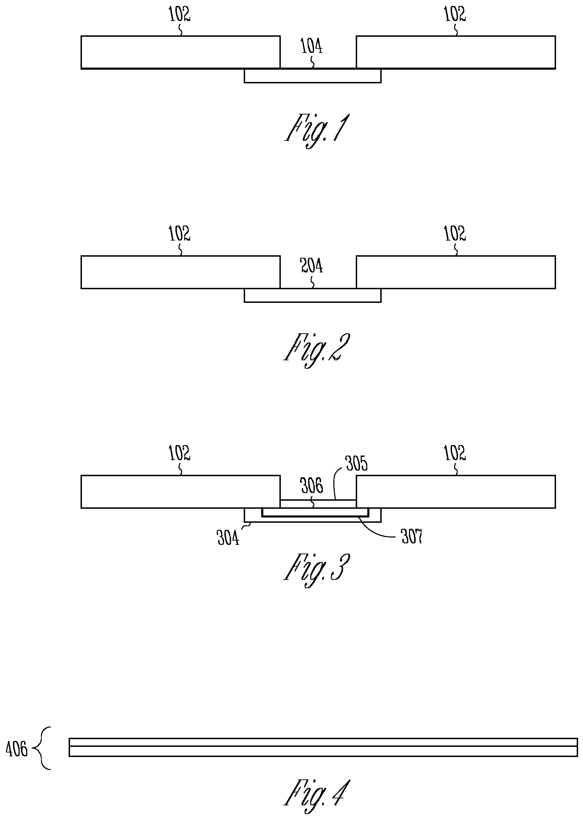

FIG. 1 is an illustration of a portion of an electronic assembly that includes two silicon (Si) dies 102 and a redistribution layer (RDL) that is an organic bridge 104. Organic bridges can comprise multiple RDLs, where the RDLs are formed out of an organic material. Organic bridges currently have a wider pitch than desired (e.g., around 1.5 microns). Also, organic bridges are susceptible to warpage, especially when exposed to higher temperatures that may be present when the systems are assembled.

FIG. 2 is an illustration of a portion of an electronic assembly that includes two silicon dies 102 and a silicon bridge 204 that can include an RDL. Silicon bridges can be formed from a silicon wafer for example. However, silicon bridges are relatively expensive and may have a longer process flow than desired.

FIG. 3 is an illustration of a portion of an electronic assembly that includes two silicon (Si) dies 102 and a glass bridge 304. The glass bridge 304 can include bonding pads and through glass vias (TGVs) to route signals from the silicon die 102 through the glass bridge. The glass bridge 304 can include a glass substrate having one or more redistribution layers 305 on the glass substrate. The redistribution layers 305 can be made of organic material and include electrically conductive traces 306 (e.g., metal traces) to route signals between the silicon dies. The glass bridge 304 can be connected to more than two silicon dies and include conductive traces to route signals among the several silicon dies.

The glass bridge 304 may include one or both of surface interconnect and buried interconnect. The surface interconnect can include conductive traces 306 on the surface of the glass substrate or conductive traces 306 included in the redistribution layer 305 and adjacent to the glass substrate. The buried interconnect can include conductive traces 307 in a buried layer of the glass substrate. Multiple glass layers can be built up (e.g., bonded together) into the glass bridge 304. The conductive traces 307 can be added to individual layers (e.g., between glass layers) to form buried interconnect in the glass bridge 304. Using multiple glass layers also allows for tuning regarding the coefficient of thermal expansion (CTE) of the glass bridge 304 to reduce warpage.

FIG. 4 is an illustration of an example of a two-layer glass bridge 406. The glass layers have different CTEs and may have different thicknesses. The top layer may have a CTE and thickness that results in positive warpage. The bottom layer may have a CTE and thickness that results in negative warpage opposite the top layer. The difference in warpage direction causes the combination of layers to better resist an overall warpage than each single layer alone. The CTEs of the layers can be reversed, with the top layer having a negative warpage and the bottom layer having a positive warpage.

The two glass layers of the glass bridge in FIG. 4 can have different thickness, warpages and CTEs. Multilayer bridges can be realized be bonding multiple single layer bridges or multiple double layer bridges. The multi-layer glass bridges may have conductive traces that run horizontally between glass layers and TGVs that extend from a surface of the glass bridge to one or more conductive traces for routing between silicon dies. The multi-layer glass bridges may have glass vias that extend between layers of conductive traces and do not extend to the surface. The glass vias can be formed in a glass layer before it is bonded to another glass layer.

The trend to package multiple IC dies like chiplets into one electronic system can lead to needing large package sizes to fit all the dies. The current package technologies for electronic packaging are limited in the area form factor (e.g., X-Y dimension) that can be achieved due to warping.

The susceptibility to warping limits the number of IC dies that can be included in multi-dies assemblies and limits the size of an electronic package. Package warpage is the deviation from flatness caused by internal stress of the electronic package. Warpage can lead to different solder joint geometries between the center and the edge of the interposer area, which can reduce the reliability. In addition, warpage can lead to solder balls bridging and interconnect opens or shorts between the solder balls which reduces the assembly yield.

A package stiffener can be used to make the electronic package less susceptible to warping, but package stiffeners are typically limited to the periphery or edges of the electronic package and only reduce the susceptibility of the package edges to warping. An ultra-thin core (UTC) package can reduce susceptibility to warping but the thickness (Z-dimension) of the package increases with the increase in form factor (X-Y dimensions) of the electronic package. To meet the demand for increased functional complexity in smaller devices, semiconductor substrate packaging can include stiffening layers. The stiffening layers can be made of ceramic or glass. In some aspects, the stiffening layer is a multi-layer stack including at least one glass layer and at least one ceramic layer. While not shown in FIG. 4, bridge 406 may include one or more redistribution layers.

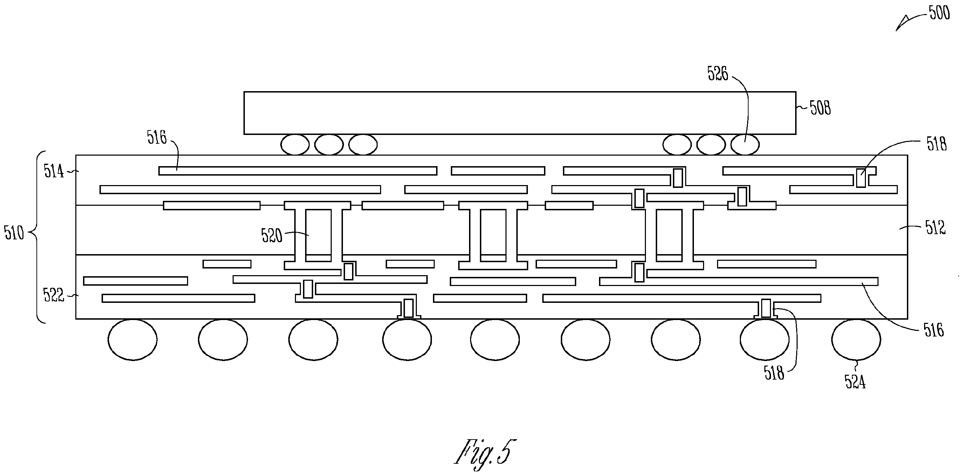

FIG. 5 is an illustration of an example of portions of an electronic device with improved robustness with regard to package warping. The electronic device 500 includes a System on Chip (SoC) device 508 attached to a substrate 510. The substrate 510 includes a stiffening layer that is a core layer 512. The stiffening core layer 512 is made of a ceramic (e.g., aluminum oxide or silicon oxide). Because the core layer 512 is ceramic, the core layer 512 is a warpage compensation layer within the substrate 510 that reduces the susceptibility of the entire electronic package to warping compared to a substrate made only with an organic material such as FR4.

The substrate 510 includes a first RDL attached to the top surface of the core layer 512. The RDL 514 includes multiple sublayers of electrically conductive traces 516 (e.g., metal traces) formed in a dielectric that is an organic material. The RDL 514 includes micro vias 518 that are connected to the conductive traces 516. The micro vias 518 provide electrical continuity between conductive traces on different sublayers of the RDL 514.

The ceramic core layer 512 includes through layer vias (TLVs) (e.g., through ceramic vias, or TCVs). In some examples, the TLVs 520 include plated through holes (PTHs). The PTHs may have having a sidewall plating that includes metal (e.g., one or more of titanium and copper).

The electronic device 500 shows one SoC device 508 attached to the top surface of the first RDL 514 for simplicity of the diagram, but there may be many ICs (e.g., chiplets) or multiple SoCs arranged on the top surface of the RDL 514 and the substrate 512 may have a large X-Y dimension. The SoC 508 includes bonding pads and solder bumps 526, and the top surface of the first RDL also induces bonding pads to connect to the solder bumps 526. Features on the top surface of the first RDL may have a finer pitch than features on the bottom surface of the second RDL. The conductive traces 516 of the first RDL provide electrical continuity between the bonding pads of the SoC 508 and the TLVs 520 of the core layer 512, the TLVs 520 provide electrical continuity between the conductive traces 516 of the first RDL and the second RDL, and the conductive traces 516 of the second RDL 522 provide electrical continuity between the TLVs 520 and the solder bumps 524. The solder bumps 524 may be used to connect the electronic device 500 to a higher level assembly (e.g., a motherboard).

The ceramic core layer 512 can compensate for the warpage of the remaining layers of substrate stack and reduce warpage of the substrate 512 and warpage of the device package during soldering. The CTEs of the RDLs and the ceramic can be selected to facilitate reduced warpage during a specific process.

In some examples, the substrate 510 can include a second core layer (not shown) if desired. The second core layer can be attached to the bottom surface of the second RDL 522. A third RDL can be attached to the second core layer and be the bottom layer that includes the bonding pads for the solder bumps 524. In some examples, the second core layer can be the bottom layer that includes the bonding pads.

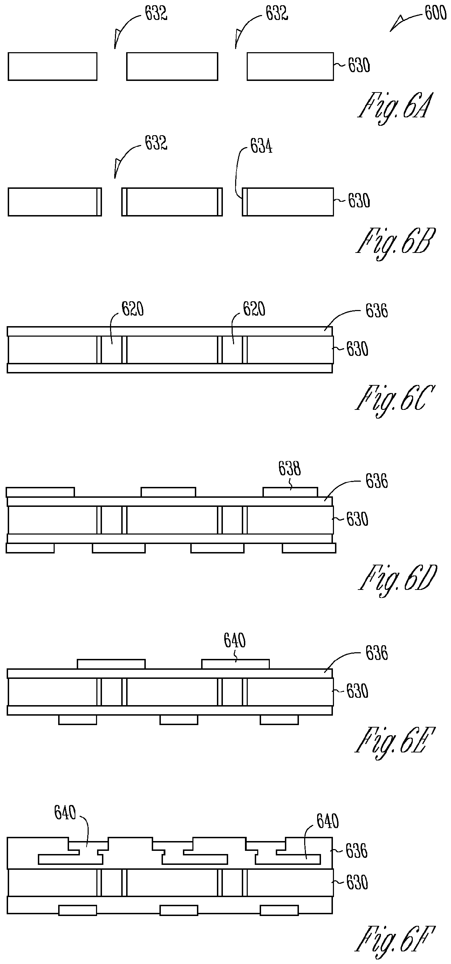

FIGS. 6A- 6F illustrate portions of an example of a process flow of forming a substrate having a stiffening ceramic core layer. The process 600 may be used in forming the substrate 510 of FIG. 5.

In FIG. 6A, a ceramic 630 (e.g., alumina or silica) is drilled (e.g., by laser drilling) to form openings 632 for what will be the TLVs. The ceramic 630 may be mounted on a production carrier (not shown) when the drilling is performed, and the production carrier is later removed. In FIG. 6B, the openings 632 are plated with a metal 634 (e.g., copper). In FIG. 6C shows forming the dielectric 636. The dielectric is formed in the openings 632 to form PTHs as TLVs 620. Dielectric layers are formed on the top and bottom surfaces of the ceramic layer 630.

In FIG. 6D, photo resist 638 is patterned on the dielectric layers using photolithography. A seed layer is deposited on the area exposed by the photo resist. In some examples, a seed layer is sputtered onto a dielectric layer before the photo resist. In FIG. 6E, the resist is removed after metal plating, and seed etching is used to pattern the metal to form conductive traces 640. In FIG. 6F, the layer including the conductive traces 640 is filled in with dielectric and additional layers of metal and dielectric are built up on the ceramic 630 to form a substrate with a ceramic core. Steps of the process can be repeated to create the RDLs and ceramic layers desired in the substrate. The process flow 600 may continue with the generation of built-up layers according to a standard printed circuit board (PCB) process. Multiple IC s may be arranged on the top surface of the substrate. Bonding pads and solder bumps may be attached to the bottom surface of the substrate.

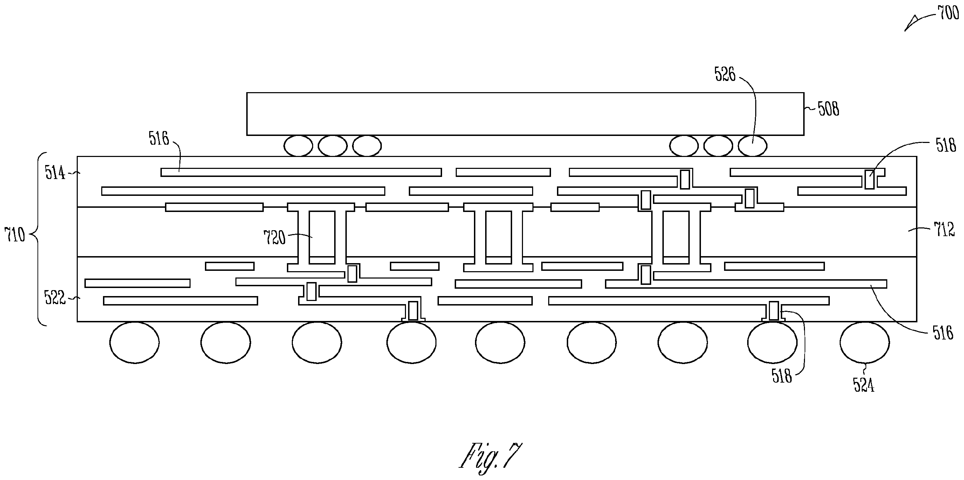

FIG. 7 is an illustration of another example of portions of an electronic device with improved robustness with regard to package warping. As in the example of FIG. 5, the electronic device 700 of FIG. 7 includes an SoC device 508 attached to a substrate 710 and the substrate 710 includes a stiffening core layer 712. The difference is that in the example of FIG. 7, the stiffening core layer 712 is made of glass (e.g., silicate glass).

In addition to the advantage of reducing warpage of the substrate and improving coplanarity as compared to an organic core, the glass core 712 enables transmission of high frequency signals within the package. This is particularly useful in a chiplet system that includes central processing unit (CPU) chiplets and high-bandwidth memory chiplets in a disaggregated CPU architecture. Glass also has lower thermal conductivity than silicon and a glass core may provide a layer of thermal insulation.

The substrate 710 includes a first RDL 514 attached to the top surface of the glass core layer 712 and a second RDL 522 on the bottom surface of the glass core 712. The glass core layer 712 includes TLVs 720 (e.g., through glass vias, or TGVs) or PTHs. The conductive traces 516 of the first RDL 514 provide electrical continuity between the bonding pads of the SoC 508 and the TLVs 720 of the glass core layer 712, the TLVs 720 provide electrical continuity between the conductive traces 516 of the first RDL 514 and the second RDL 522, and the conductive traces 516 of the second RDL 522 provide electrical continuity between the TLVs 520 and the solder bumps 524.

The glass core layer 712 may be comprised of multiple layers of non-identical glass. The glass core layer may have two glass layers as in the example of FIG. 4. The two glass layers may differ in one or more of thickness, warpage, and CTE. The glass core layer 712 may be a multilayer glass core having multiple single glass layers bonded together or multiple double glass layers bonded together. The multi-layer glass core may be a glass RDL and may have conductive traces that run horizontally between glass layers and TGVs that extend from a surface of the glass core to one or more conductive traces for routing. The multi-layer glass core may have TGVs that extend between layers of conductive traces and do not extend to the surface. The TGVs can be formed in a glass layer before it is bonded to another glass layer, or the TGVs may be formed in the composite glass layer after the multiple layers are bonded together.

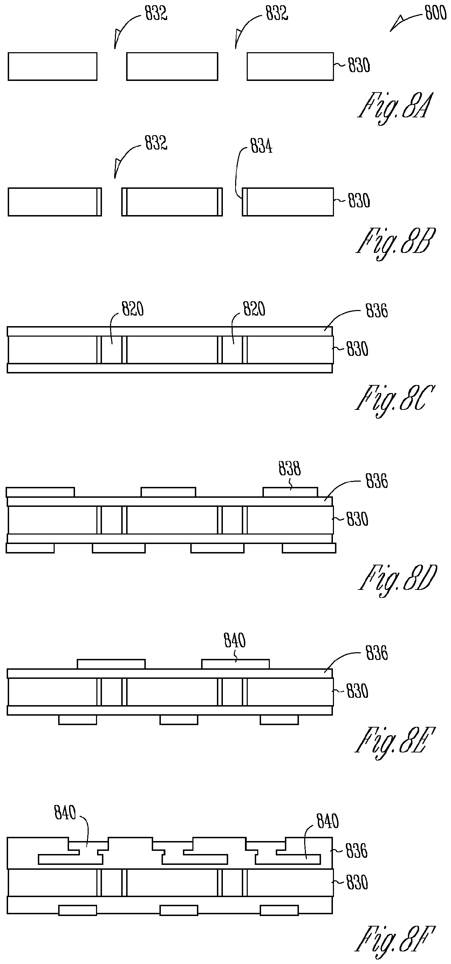

FIGS. 8A-8F illustrate portions of an example of a process flow of forming a substrate having a stiffening glass core layer. The process 800 may be used in forming the substrate 710 of FIG. 7.

In FIG. 8A, a stiffening glass layer 830 is drilled (e.g., using laser drilling) to form openings 832 for what will be the TGVs. The glass layer 830 may be a uniform glass layer or may be made of multiple layers of glass bonded together. The glass layer 830 may be mounted on a production carrier (not shown) when the drilling is performed, and the production carrier is later removed. In FIG. 8B, the openings 832 are plated with a metal 834 (e.g., copper). In FIG. 8C shows forming the dielectric 836. The dielectric is formed in the openings 832 to form TGVs 820. Dielectric layers are formed on the top and bottom surfaces of the glass layer 830.

In FIG. 8D, photo resist 838 is patterned on the dielectric layers using photolithography. A metal seeding is deposited on the area exposed by the photo resist. In FIG. 8E, the resist is removed after metal plating, and seed etching is used to pattern the metal to form conductive traces 840. In FIG. 8F, the metal layer including the conductive traces 840 is filled in with dielectric and additional layers of metal and dielectric are built up on the glass layer 830 to form a substrate with a glass core. Steps of the process can be repeated to create additional RDLs and glass layers of the substrate as desired. Multiple IC s may be arranged on the top surface of the substrate. Bonding pads and solder bumps may be attached to the bottom surface of the substrate.

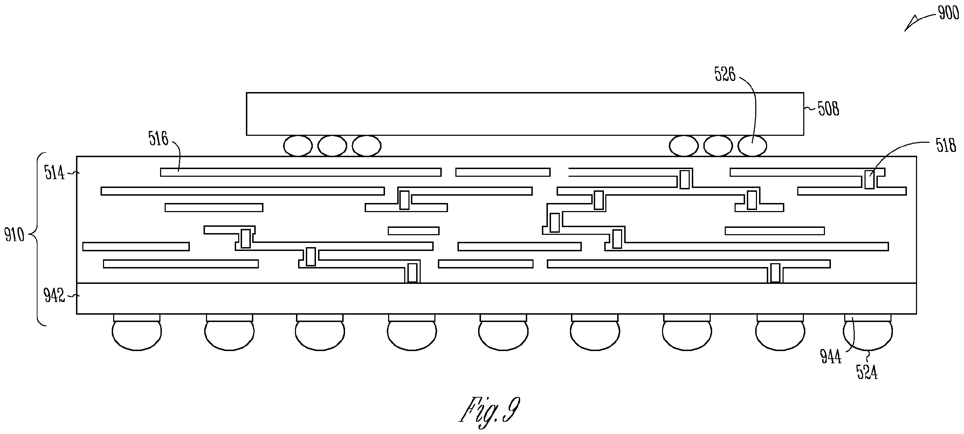

FIG. 9 is an illustration of an example of portions of an electronic device with improved robustness with regard to package warping. The electronic device 900 includes an SoC device 508 attached to a substrate 910. The substrate 910 includes a stiffening layer that is a ceramic carrier layer 942. Only one SoC device 508 is shown for simplicity of the diagram, and the electronic device 900 may include several ICs on the top surface of the substrate 910. Because the carrier layer 942 is made of a ceramic, the ceramic carrier layer 942 is a warpage compensation layer at a surface (e.g., bottom surface) of the substrate 910 that reduces the susceptibility of the entire electronic package to warping compared to a substrate made only with an organic material.

The substrate 910 includes an RDL 514 attached to the top surface of the ceramic carrier layer 942, and the SoC device 508 is attached to the top surface of the RDL 514. The RDL 514 includes electrically conductive interconnect that includes multiple sublayers of electrically conductive traces 516 and multiple micro vias 518 formed in an organic material. The bottom surface of the ceramic carrier layer 942 may be the bottom surface of the substrate 910. The bottom surface of the ceramic carrier layer 942 includes bonding pads 944 to which solder bumps 524 can be attached. The ceramic carrier layer 942 includes TLVs (not shown) to provide electrical continuity between the electrically conductive interconnect of the RDL 514 and the bonding pads 944. I There may be a thin interconnect layer (not shown) between the ceramic carrier layer 942 and bonding pads 944 to provide electrical continuity between the TLVs and the bonding pads 944. The RDL 514 provides electrical continuity between bonding pads of the SoC device 508 to the TLVs, and the TLVs provide electrical continuity from the RDL 514 to the bonding pads 944.

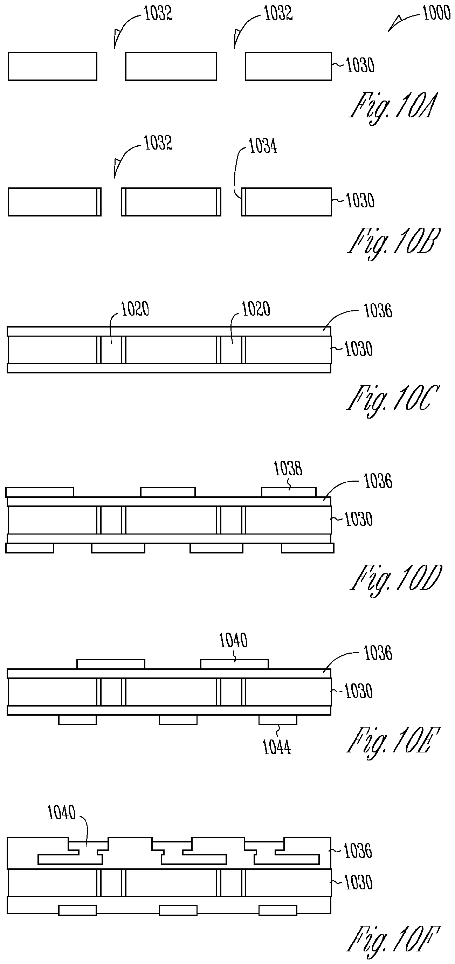

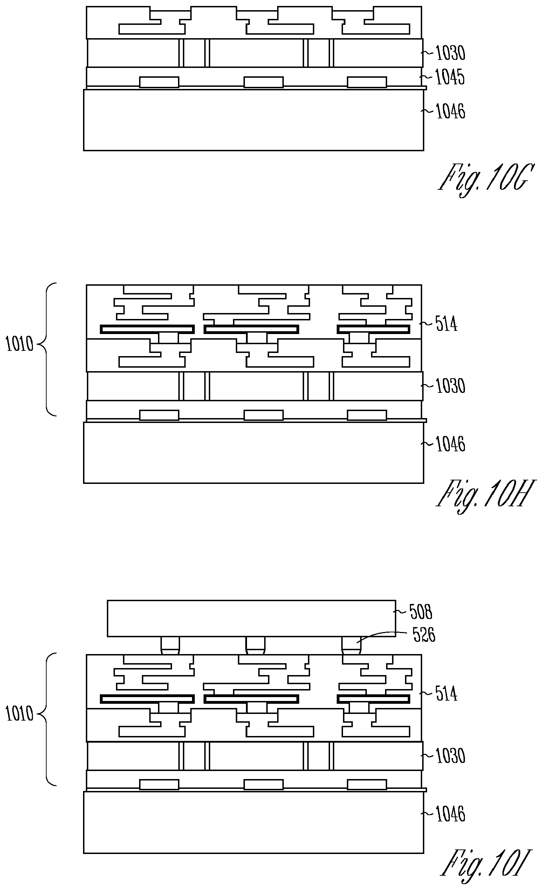

FIGS. 10A-10K illustrate portions of an example of a process flow of forming a substrate having a stiffening ceramic carrier layer 942. The process 1000 may be used in forming the substrate 910 of FIG. 9.

In FIG. 10A, a stiffening ceramic carrier layer 1030 is drilled (e.g., using laser drilling) to form openings 1032 for TLVs. In FIG. 10B, the openings 1032 are plated with metal 1034. An RDL is formed to contact the top surface of the ceramic carrier layer 1030. Layers of the RDL are built up using a dielectric and metal. In FIG. 10C, dielectric is formed in the openings 1032 to form TLVs 1020. Dielectric layers are formed on the top and bottom surfaces of the ceramic carrier layer 1030.

In FIG. 10D, photo resist 1038 is patterned on the dielectric layers using photolithography. A seed layer is deposited on the area exposed by the photo resist. In FIG. 10E, the resist 1038 is removed after metal plating, and seed etching is used to pattern the metal to form conductive traces 1040 and bonding pads 1044. In FIG. 10F, the metal layer including the conductive traces 1040 is filled in with dielectric and additional layers of metal and dielectric are built up on the ceramic carrier layer 1030. A thin dielectric layer 1045 having conductive traces may be formed between the ceramic carrier layer 1030 and bonding pads 1044 to provide electrical continuity between the TLVs and the bonding pads 1044.

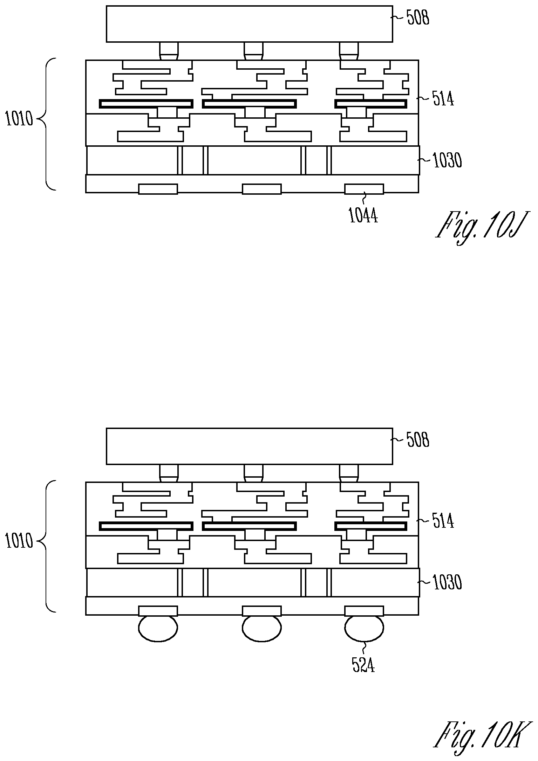

In FIG. 10G, the ceramic carrier layer 1030 is optionally bonded to a production carrier 1046. The production carrier 1046 is sacrificial and will later be removed. In FIG. 10H, a multi-layer RDL 514 is built-up to form a substrate 1010 with a stiffening ceramic carrier layer 1030. In FIG. 101, a SoC device 508 is attached to the top surface of the substrate 1010. In FIG. 10J, the substrate 1010 is released from the production carrier layer 1046. In FIG. 10K, solder bumps 524 are added to the bonding pads 1044 exposed by removal of the sacrificial production carrier 1046.

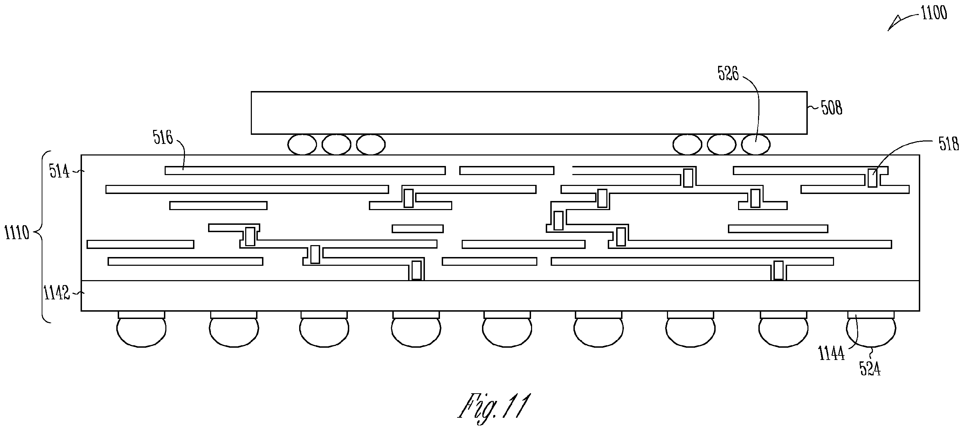

FIG. 11 is an illustration of an example of portions of an electronic device with improved robustness with regard to package warping. The electronic device 1100 includes SoC device 508 attached to a substrate 1110. The substrate 1110 includes a stiffening layer that is a glass carrier layer 1142. Because the carrier layer is made of glass, the glass carrier layer 1142 is a warpage compensation layer that reduces the susceptibility of the entire electronic package to warping compared to a substrate made only with an organic material.

The glass carrier layer 1142 may be a composite layer made of multiple layers of glass. The glass carrier layer 1142 may have two glass layers as in the example of FIG. 4. The two glass layers may differ in one or more of thickness, warpage, and CTE. The glass carrier layer 1142 may be a composite glass carrier layer having multiple single glass layers bonded together or multiple double glass layers bonded together.

The substrate 1110 includes an RDL 514 attached to the top surface of the glass carrier layer 1142, and the SoC device 508 is attached to the top surface of the RDL 514. The RDL 514 includes electrically conductive interconnect that includes multiple sublayers of electrically conductive traces 516 and multiple micro vias 518 formed in an organic material. The bottom surface of the glass carrier layer 1142 includes bonding pads 1144 to which solder bumps 524 can be attached. The glass carrier layer 1142 includes TGVs (not shown) to provide electrical continuity between the electrically conductive interconnect of the RDL 514 and the bonding pads 1144. The RDL 514 provides electrical continuity between bonding pads of the SoC device 508 to the TGVs, and the TGVs provide electrical continuity from the RDL 514 to the bonding pads 1144.

There may be a thin interconnect layer (not shown) between the glass carrier layer 1142 and bonding pads 1144 to provide electrical continuity between the TGVs and the bonding pads 1144. In some examples, the glass carrier layer 1142 may include conductive traces to provide electrical continuity between the TGVs and the bonding pads 1144. TGVs may extend from a surface of the glass carrier layer 1142 to conductive traces of the glass carrier layer 1142.

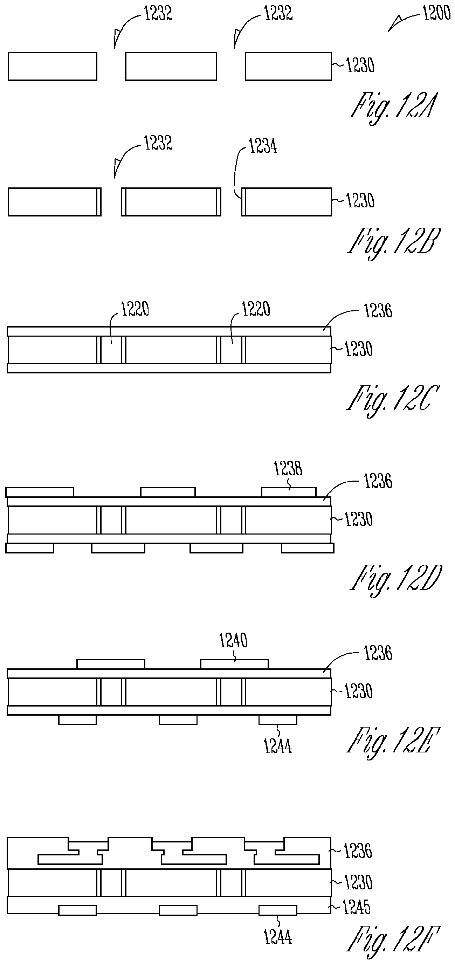

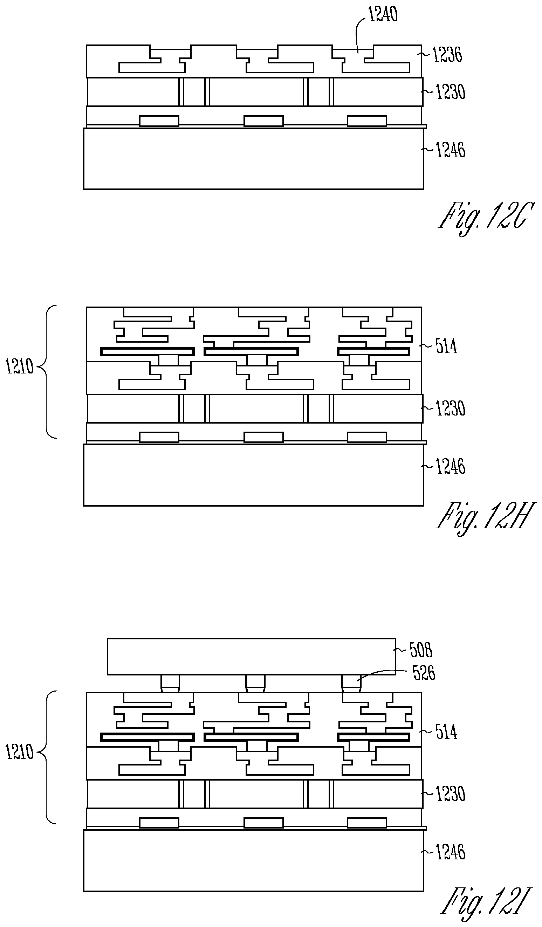

FIGS. 12A-12K illustrate portions of an example of a process flow of forming a substrate having a stiffening glass carrier layer 1142. The process 1200 may be used in forming the substrate 1110 of FIG. 11.

In FIG. 12A, a glass carrier layer 1230 is drilled (e.g., using laser drilling) to form openings 1232 for TGVs. In some examples, the glass carrier layer 1230 is a composite glass layer made of multiple layers of glass of different CTEs to set the warpage of the stiffening glass carrier layer. In FIG. 12B, the openings 1232 are plated with metal 1234. An RDL is formed to contact the top surface of the glass carrier layer 1230. Layers of the RDL are built up using a dielectric and metal. In FIG. 12C, dielectric is formed in the openings 1232 to form TGVs 1220. Dielectric layers are formed on the top and bottom surfaces of the glass carrier layer 1230.

In FIG. 12D, photo resist 1238 is patterned on the dielectric layers using photolithography. A seed layer is deposited on the area exposed by the photo resist. In FIG. 12E, the resist 1238 is removed after metal plating, and seed etching is used to pattern the metal to form conductive traces 1240 and bonding pads 1244. In FIG. 12F, the metal layer including the conductive traces 1240 is filled in with dielectric and additional layers of metal and dielectric are built up on the glass carrier layer 1230. A thin dielectric layer 1245 having conductive traces may be formed between the glass carrier layer 1230 and bonding pads 1244 to provide electrical continuity between the TGVs and the bonding pads 1244.

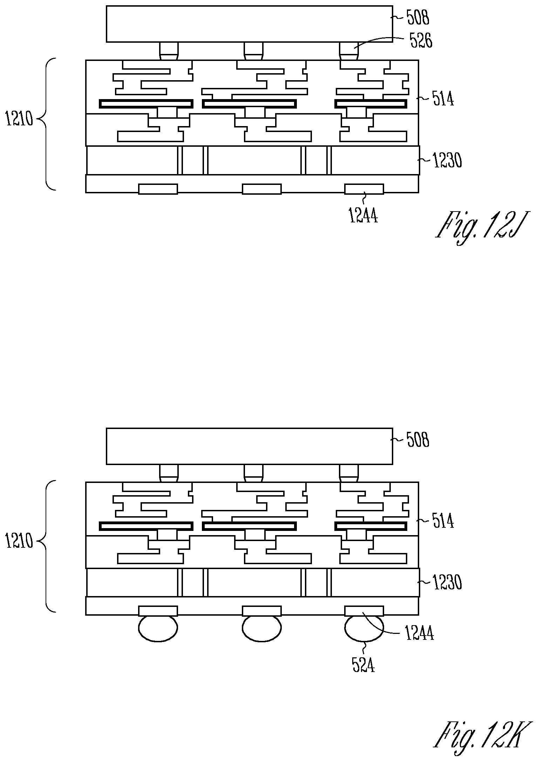

In FIG. 12G, the glass carrier layer 1230 is optionally bonded to a production carrier 1246. The production carrier 1246 is sacrificial and will later be removed. In FIG. 12H, a multi-layer RDL 514 is built-up to form a substrate 1210, thereby forming an electronic device substrate having a stiffening glass carrier layer 1230. In FIG. 121, a SoC device 508 is attached to the top surface of the substrate 1210. In FIG. 12J, the substrate 1210 is released from the production carrier 1246. In FIG. 12K, solder bumps 524 are added to the bonding pads 1244 exposed by removal of the sacrificial production carrier 1246.

The methods, devices, and systems described herein provide interconnect that can accommodate high frequency signals while providing very dense signal routing. An example of an electronic device using assemblies with system level packaging as described in the present disclosure is included to show an example of a higher level device application.

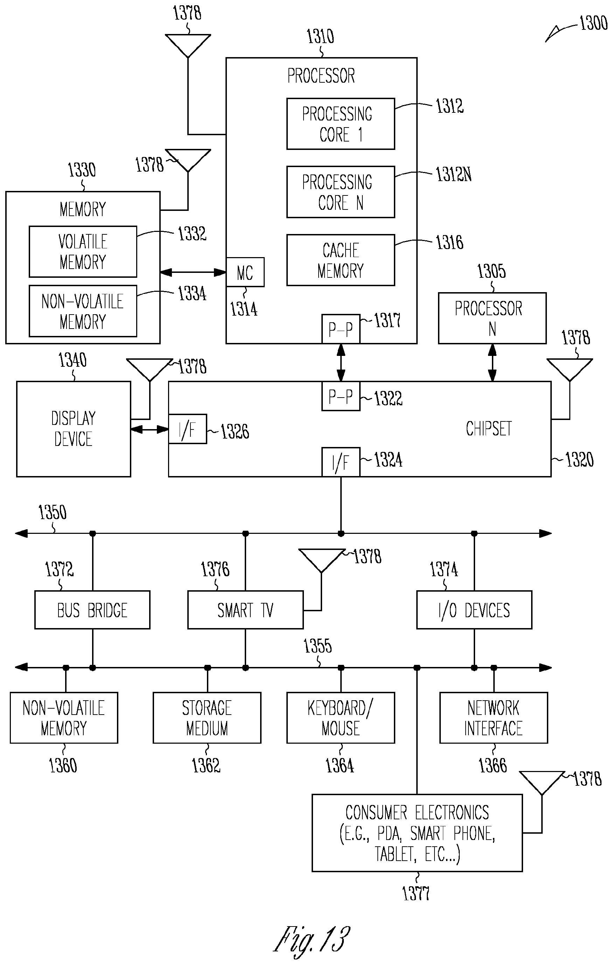

FIG. 13 illustrates a system level diagram, according to one embodiment of the invention. For instance, FIG. 13 depicts an example of a system that can include an electronic device packaged with a substrate having a stiffening layer made of ceramic or glass. In one embodiment, system 1300 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance, or any other type of computing device. In some embodiments, system 1300 is a system on a chip (SOC) system. In one example, two or more systems as shown in FIG. 13 may be coupled together using one or more glass bridges as described in the present disclosure.

In one embodiment, processor 1310 has one or more processing cores 1312 and 1312N, where N is a positive integer and 1312N represents the Nth processor core inside processor 1310. In one embodiment, system 1300 includes multiple processors including 1310 and 1305, where processor 1305 has logic similar or identical to the logic of processor 1310. In some embodiments, processing core 1312 includes, but is not limited to, pre-fetch logic to fetch instructions, decode logic to decode the instructions, execution logic to execute instructions and the like. In some embodiments, processor 1310 has a cache memory 816 to cache instructions and/or data for system 1300. Cache memory 1316 may be organized into a hierarchal structure including one or more levels of cache memory.

In some embodiments, processor 1310 includes a memory controller 1314, which is operable to perform functions that enable the processor 1310 to access and communicate with memory 1330 that includes a volatile memory 1332 and/or a non-volatile memory 1334. In some embodiments, processor 1310 is coupled with memory 1330 and chipset 1320. Processor 1310 may also be coupled to a wireless antenna 1378 to communicate with any device configured to transmit and/or receive wireless signals. In one embodiment, the wireless antenna interface 1378 operates in accordance with, but is not limited to, the IEEE 802.11 standard and its related family, Home Plug AV (HPAV), Ultra-Wide Band (UWB), Bluetooth, WiMax, or any form of wireless communication protocol.

In some embodiments, volatile memory 1332 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. Non-volatile memory 1334 includes, but is not limited to, flash memory, phase change memory (PCM), read-only memory (ROM), electrically erasable programmable read-only memory (EEPROM), or any other type of non-volatile memory device.

Memory 1330 stores information and instructions to be executed by processor 1310. In one embodiment, memory 1330 may also store temporary variables or other intermediate information while processor 1310 is executing instructions. In the illustrated embodiment, chipset 1320 connects with processor 1310 via Point-to-Point (PtP or P-P) interfaces 1317 and 1322. Chipset 1320 enables processor 1310 to connect to other elements in system 1300. In some embodiments of the invention, interfaces 1317 and 1322 operate in accordance with a PtP communication protocol such as the Intel^{®} QuickPath Interconnect (QPI) or the like. In other embodiments, a different interconnect may be used.

In some embodiments, chipset 1320 is operable to communicate with processor 1310, 1305N, display device 1340, and other devices 1372, 1376, 1374, 1360, 1362, 1364, 1366, 1377, etc. Buses 1350 and 1355 may be interconnected together via a bus bridge 1372. Chipset 1320 connects to one or more buses 1350 and 1355 that interconnect various elements 1374, 1360, 1362, 1364, and 1366. Chipset 1320 may also be coupled to a wireless antenna 1378 to communicate with any device configured to transmit and/or receive wireless signals. Chipset 1320 connects to display device 1340 via interface (I/F) 1326. Display 1340 may be, for example, a touchscreen, a liquid crystal display (LCD), a plasma display, cathode ray tube (CRT) display, or any other form of visual display device. In some embodiments of the invention, processor 1310 and chipset 1320 are merged into a single SOC. In one embodiment, chipset 1320 couples with (e.g., via interface 1324) a non-volatile memory 1360, a mass storage medium 1362, a keyboard/mouse 1364, and a network interface 1366 via I/F 824 and/or I/F 1326, I/O devices 1374, smart TV 1376, consumer electronics 1377 (e.g., PDA, Smart Phone, Tablet, etc.).

In one embodiment, mass storage medium 1362 includes, but is not limited to, a solid state drive, a hard disk drive, a universal serial bus flash memory drive, or any other form of computer data storage medium. In one embodiment, network interface 1366 is implemented by any type of well-known network interface standard including, but not limited to, an Ethernet interface, a universal serial bus (USB) interface, a Peripheral Component Interconnect (PCI) Express interface, a wireless interface and/or any other suitable type of interface. In one embodiment, the wireless interface operates in accordance with, but is not limited to, the IEEE 802.11 standard and its related family, Home Plug AV (HPAV), Ultra-Wide Band (UWB), Bluetooth, WiMax, or any form of wireless communication protocol.

While the modules shown in FIG. 13 are depicted as separate blocks within the system 1300, the functions performed by some of these blocks may be integrated within a single semiconductor circuit or may be implemented using two or more separate integrated circuits. For example, although cache memory 1316 is depicted as a separate block within processor 1310, cache memory 1316 (or selected aspects of 1316) can be incorporated into processor core 1312.

The devices, systems, and methods described can provide improved routing of interconnection between ICs for a multichip package by providing a stiffening layer in the packaging to reduce warping, such as when the package is exposed to a temperature during manufacturing. Examples described herein include one SoC for simplicity, but one skilled in the art would recognize upon reading this description that the examples can include more than one SoC system.

### ADDITIONAL DESCRIPTION AND EXAMPLES

Example 1 includes subject matter (such as an electronic device) comprising a substrate including an organic material, a glass bridge die included in the substrate, a first IC die and at least a second IC die. The glass bridge die includes electrically conductive interconnect. The first IC die and the at least the second IC die are arranged on a surface of the substrate and include bonding pads connected to the interconnect of the glass bridge die.

In Example 2, the subject matter of Example 1 optionally includes the glass bridge die including multiple glass layers bonded together.

In Example 3, the subject matter of Example 2 optionally includes a first glass layer of the multiple glass layers having a different coefficient of thermal expansion than another glass layer.

In Example 4, the subject matter of claim 3, wherein the interconnect of the glass bridge die includes at least one conductive trace between the first glass layer and the other glass layer.

In Example 5, the subject matter of one or any combination of Examples 2-4 optionally includes the interconnect of the glass bridge die including a via extending from a surface of the glass bridge die to the at least one conductive trace.

In Example 6, the subject matter of one or any combination of Examples 1-5 optionally includes the glass bridge die including a uniform glass layer.

In Example 7, the subject matter of one or any combination of Examples 1-6 optionally includes the glass bridge die including a through glass via (TGV) extending from a first surface of the glass bridge die to a second surface of the glass bridge die.

In Example 8, the subject matter of one or any combination of Examples 1-7 optionally includes the glass bridge die including a surface coplanar with a surface of the substrate.

In Example 9, the subject matter of one or any combination of Examples 1-8 optionally includes the interconnect of the glass bridge die includes bonding pads connected to the bonding pads of the first IC die.

In Example 10, the subject matter of one or any combination of Examples 1-9 optionally includes the first IC die and the at least the second IC die include multiple chiplets.

Example 11 includes subject matter (such as a method of forming an electronic device) or can optionally by combined with one or any combination of Examples 1-10 to include such subject matter, comprising forming a substrate including an organic material, forming a glass bridge die in the substrate, disposing a first integrated circuit (IC) and at least a second IC on a surface of the substrate, and connecting bonding pads of the first IC and the second IC to electrically conductive interconnect of the glass bridge die.

In Example 12, the subject matter of Example 11 optionally includes bonding multiple glass layers bonded together, wherein a first glass layer of the multiple glass layers has a different coefficient of thermal expansion than another glass layer.

In Example 13, the subject matter of Example 12 optionally includes forming at least a portion of the electrically conductive interconnect between the first glass layer and the other glass layer.

In Example 14, the subject matter of one or both of Examples 12 and 13 optionally includes forming a via extending from a surface of the glass bridge to the at least the portion of the electrically conductive interconnect between the first glass layer and the other glass layer.

In Example 15, the subject matter of one or any combination of Examples 11-14 optionally includes forming a uniform glass layer, and forming the electrically conductive interconnect on a surface of the uniform glass layer.

Example 16 includes subject matter (such as a packaged electronic system) or can optionally be combined with one or any combination of Examples 1-5 to include such subject matter, comprising a substrate including an organic material, a glass bridge die included in the substrate, the glass bridge die including electrically conductive interconnect, multiple chiplets disposed on a surface of the substrate and including bonding pads and bonding pads of at least two chiplets are connected to the electrically conductive interconnect of the glass bridge die, and an antenna operatively coupled to at least one of the chiplets.

In Example 17, the subject matter of Example 16 optionally includes the glass bridge die including multiple glass layers bonded together.

In Example 18, the subject matter of Example 17 optionally includes a first glass layer of the multiple glass layers has a different coefficient of thermal expansion than another glass layer.

In Example 19, the subject matter of one or both of Examples 17 and 18 optionally includes the interconnect of the glass bridge die including at least one conductive trace between the first glass layer and the other glass layer.

In Example 20, the subject matter of one or any combination of Examples 17-19 optionally includes the interconnect of the glass bridge die including a via extending from a surface of the glass bridge to the at least one conductive trace.

In Example 21, the subject matter of Example 16 optionally includes the glass bridge die including a uniform glass layer.

In Example 22, the subject matter of one or any combination of Examples 16-21 optionally includes the glass bridge die including a through glass via (TGV) extending from a first surface of the glass bridge die to a second surface of the glass bridge die.

In Example 23, the subject matter of one or any combination of Examples 16-22 optionally includes the glass bridge die including a surface coplanar with a surface of the substrate.

In Example 24, the subject matter of one or any combination of Examples 16-23 optionally includes the glass bridge die including bonding pads connected to the bonding pads of the first IC die.

These non-limiting examples can be combined in any permutation or combination. The Abstract is provided to allow the reader to ascertain the nature and gist of the technical disclosure. It is submitted with the understanding that it will not be used to limit or interpret the scope or meaning of the claims. The following claims are hereby incorporated into the detailed description, with each claim standing on its own as a separate embodiment.

## Claims

1. An electronic device comprising:
a substrate including an organic material;
a glass bridge die included in the substrate, the glass bridge die including electrically conductive interconnect; and
a first integrated circuit (IC) die and at least a second IC die arranged on a surface of the substrate and including bonding pads connected to the electrically conductive interconnect of the glass bridge die.

2. The electronic device of claim 1, wherein the glass bridge die includes multiple glass layers bonded together.

3. The electronic device of claim 2, wherein a first glass layer of the multiple glass layers has a different coefficient of thermal expansion than another glass layer.

4. The electronic device of claim 3, wherein the interconnect of the glass bridge die includes at least one conductive trace between the first glass layer and the other glass layer.

5. The electronic device of claim 2 or claim 3, wherein the interconnect of the glass bridge die includes a via extending from a surface of the glass bridge to the at least one conductive trace.

6. The electronic device of claim 1, wherein the glass bridge die includes a uniform glass layer.

7. The electronic device of any one of claims 1-6, wherein the glass bridge die includes a through glass via (TGV) extending from a first surface of the glass bridge die to a second surface of the glass bridge die.

8. The electronic device of any one of claims 1-7, wherein the glass bridge die includes a surface coplanar with a surface of the substrate.

9. The electronic device of any one of claims 1-8, wherein the interconnect of the glass bridge die includes bonding pads connected to the bonding pads of the first IC die.

10. The electronic device of any one of claims 1-9, wherein the first IC die and the at least the second IC die include multiple chiplets.

11. The electronic device of any one of claims 1-10, including:
at least one organic layer of organic material on the glass bridge die, the organic layer including an electrically conductive trace having a first end and a second end; and
wherein the first IC die is electrically coupled to the first end of the trace, and the second IC die is electrically coupled to the second end of the trace.

12. The electronic device of any one of claims 1-11, wherein the glass bridge die includes at least two glass layers, and the electrically conductive interconnect includes an electrically conductive trace located between the at least two glass layers.

13. A packaged electronic system, the system comprising:
a substrate including an organic material;
a glass bridge die included in the substrate, the glass bridge die including electrically conductive interconnect;
multiple chiplets disposed on a surface of the substrate and including bonding pads wherein bonding pads of at least two chiplets are connected to the electrically conductive interconnect of the glass bridge die; and
an antenna operatively coupled to at least one of the chiplets.

14. The system of claim 13, wherein the glass bridge includes multiple glass layers bonded together.

15. The system of claim 14, wherein a first glass layer of the multiple glass layers has a different coefficient of thermal expansion than another glass layer.
